Europäisches Patentamt

European Patent Office

Office européen des brevets

(11) Publication number: **0 093 557**
**B1**

# EUROPEAN PATENT SPECIFICATION

(45) Date of publication of patent specification: **12.07.89**

(51) Int. Cl.⁴: **H 01 L 27/08, H 01 L 27/12, H 01 L 29/24**

(21) Application number: **83302315.3**

(22) Date of filing: **22.04.83**

(54) **High-speed complementary semiconductor integrated circuit.**

(30) Priority: **26.04.82 JP 68844/82**

(43) Date of publication of application:
**09.11.83 Bulletin 83/45**

(45) Publication of the grant of the patent:
**12.07.89 Bulletin 89/28**

(84) Designated Contracting States:
**DE FR GB NL**

(56) References cited:
**FR-A-2 123 337**
**FR-A-2 268 361**
**FR-A-2 323 229**
**US-A-3 405 331**
**US-A-4 126 732**
**US-A-4 171 996**

**THIN SOLID FILMS, vol. 6, 1970, pages R36-R38, Elsevier Sequoia S.A.; Lausanne, CH; S. CARNARU et al.: "PbTe thin-film field-effect transistors"**

(73) Proprietor: **KABUSHIKI KAISHA TOSHIBA**
**72, Horikawa-cho Saiwai-ku**
**Kawasaki-shi Kanagawa-ken 210 (JP)**

(72) Inventor: **Nii, Riro**
**5-5-11, Higashifushimi**
**Hoya-shi Tokyo (JP)**
Inventor: **Toyoda, Nobuyuki**
**A 302 Tokyu-Tana-dwell 8-5, Tana-cho**
**Midori-ku Yokohama-shi (JP)**
Inventor: **Hojo, Akimichi**
**8-7-17, Konandai**
**Konan-ku Yokohama-shi (JP)**
Inventor: **Yanai, Hisayoshi**
**2-20-14, Amanuma Suginami-ku**
**Tokyo (JP)**

(74) Representative: **Freed, Arthur Woolf et al**
**MARKS & CLERK 57-60 Lincoln's Inn Fields**
**London WC2A 3LS (GB)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

## Description

The present invention relates to a semiconductor device having a high-speed operation. More specifically, the present invention is concerned with a semiconductor integrated circuit device which operates with high-speed and which is of a complementary structure.

As is commonly known in the art, the operational speed of a semiconductor integrated circuit device is limited by the carrier mobility of electrons or holes allowed to flow between the elements. Therefore, when it is desired to improve the operational speed of the device, it is necessary to increase the carrier mobility. For the purpose of increasing the carrier mobility to a value greater than that of the carrier mobility of silicon, the semiconductive material currently in use, methods which include (1) using a compound semiconductive material such as GaAs, $Al_xGa_{1-x}As$, etc. which, in an atmosphere of room temperature, has an electron mobility of $8\times10^3$ cm$^2$/V · sec or so at maximum to form the active elements, (2) applying a novel impurity addition technique such as a modulation doping technique to a semiconductor device composed of such a compound semiconductive material and thereby improving or increasing the electron mobility in a zone of low temperature, etc. have been studied.

However, the carrier mobility of a semiconductor integrated circuit device prepared by the above-mentioned methods is several thousands of square centimeters/V · sec to several tens of thousands of square centimeters/V · sec at best. When an attempt is made to further improve the carrier mobility, the manufacturing yield of the semiconductor device decreases due to the technical problem involved in the manufacturing steps.

Further, as is well known, the semiconductor device of a complementary circuit structure has excellent characteristics such as a high degree of permissible noise, a low power consumption, etc. and is therefore regarded as being a promising device providing excellent cost performance. On the other hand, however, the operational speed of the complementary semiconductor integrated circuit device is limited by the smaller one of its electron or hole mobility. Accordingly, even when electron mobility greater than the carrier (electron) mobility of silicon has been actualized by using GaAs or $Al_xGa_{1-x}As$ at the time of forming the device as mentioned above, the hole mobility at room temperature of the said compound semiconductive material is only several hundreds of square centimeters/V · sec at most, with the result that the final operational speed of the complementary semiconductor device is not improved because, even when the mobility of one carrier (electron) of the complementary semiconductor device is increased, the final operational speed is limited by this inferior-hole mobility if the mobility of the other carrier (hole) is relatively small. Accordingly, the increase in speed of the complementary semiconductor integrated circuit does not reach the desired speed even if concurrent use is made of a technique for lowering the atmospheric temperature.

The object of the present invention is to provide a new and improved semiconductor device has has excellent hole and electron carrier mobilities and which has high-speed operation even when it is applied to a complementary circuit structure.

Document FR—A—2 268 361 discloses a semiconductor device having two FETs, the device being silicon based. Document FR—A—2 123 337 discloses a complementary semiconductor device in which the active elements are implemented using lead sulfide.

The present invention seeks to provide an improved arrangement.

According to the present invention there is provided a semiconductor device having a substrative body and first and second active elements formed on said substrative body and performing a mutual and complementary switching operation, characterised in that said substrative body comprises a substrate having a surface and being composed of a monocrystalline bulk of lead chalcogenide based semiconductive material, and an insulative film formed on the substrate surface and made of a monocrystalline dielectric material which is lattice-matched with the lead chalcogenide material constituting said substrate, and that said first and second active elements comprise first and second metal-insulator-semiconductor field effect transistors or MISFETs which are formed on said insulative film to have gate insulation films made of monocrystalline dielectric material and which MISFETs are made of a lead chalcogenide based semiconductive material having electron and hole mobilities whose values are each greater by at least one order of magnitude than those of silicon material, said first and second MISFETs being prevented from being formed directly on said substrate, whereby irregularities in crystalline structure of the substrate surface are removed in the growth process of said insulative film on said substrate, so that said first and second MISFETs are prevented from having imperfections and lattice defects causing the operation speed thereof to be decreased.

According to the integrated circuit device of the invention, the active elements are preferably formed of lead chalcogenide based semiconductive material such as PbS, PbSe, or PbTe. This type of semiconductive material is higher both in electron mobility and in hole mobility than silicon and the values of its electron and hole mobilities are approximate to each other. The lead chalcogenide semiconductive material has, in a temperature zone of, for example, liquid helium, electron and hole carrier mobilities of several tens of thousands of square centimeters to several hundreds of thousands of square centimeters/ V · sec. According to the present invention, therefore, there is provided a semiconductor integrated circuit device which has higher speed than that of the conventional semiconductor integrated circuit device to the extent corresponding to an increase, by at least one order of magnitude, of the operational speed value of that conventional one. Thus, the above object is attained.

The above-mentioned active elements constituting the complementary semiconductor integrated circuit of the present invention are constituted by MISFETs. In a pair of transistors, which perform a logical switching operation on a mutually complementary basis, one of such transistors operates with the holes as its "active carrier" and the other thereof operates with the electron as its "active carrier". The wording "active carrier" used in this specification and claims is defined to mean "carrier directly serving to perform the active function of the transistor".

Embodiments of the invention will now be described by way of example only and with reference to the accompanying drawings, in which:

Fig. 1 is a sectional view schematically showing the construction of a main part of a complementary integrated inverter device;

Fig. 2 is a circuit diagram showing an equivalent circuit of the inverter circuit device of Fig. 1; and

Fig. 3 is a sectional view schematically showing the construction of a complementary integrated inverter device modified according to one embodiment of the present invention.

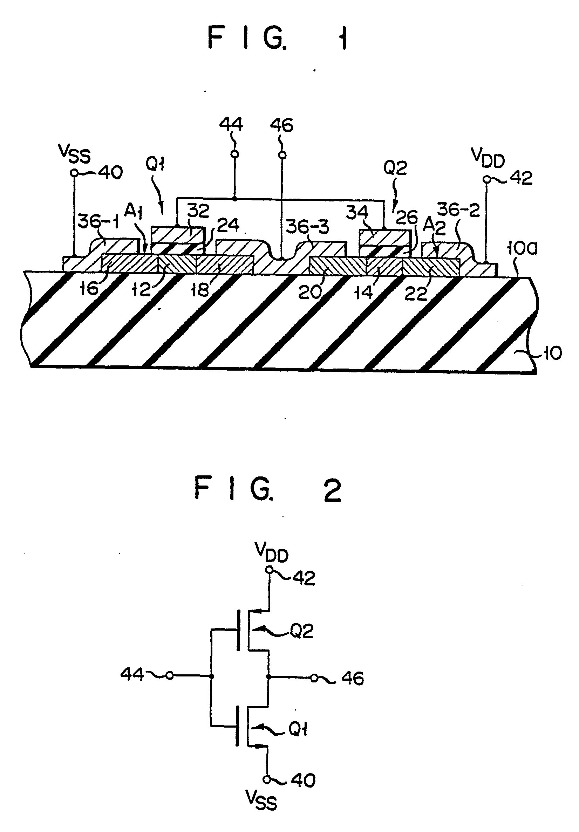

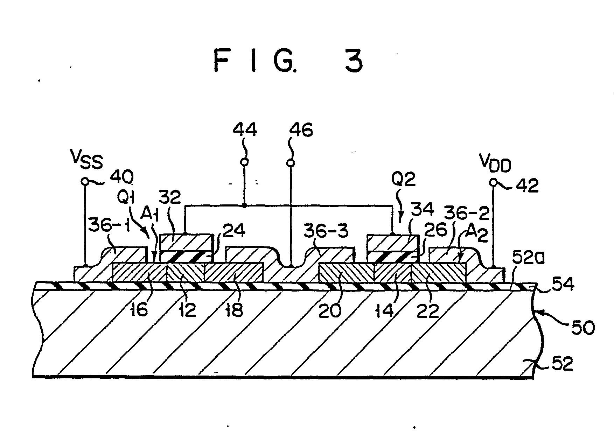

Referring now to Fig. 1 a monocrystalline substrate 10 consisting of an electrically insulative substrate such as $BaF_2$ has a cleavage plane 10a corresponding to a specified crystalline face on its upper surface. On the cleavage plane 10a of this $BaF_2$ substrate 10, an n-conductivity type thin monocrystalline film $A_1$ and a p-conductivity type monocrystalline thin film $A_2$ are each deposited by being selectively epitaxially grown thereon through the use of, a molecular beam epitaxy technique, for example. These films $A_1$ and $A_2$ are each formed of a semiconductor crystalline body which has higher carrier mobility or electron and hole mobilities than silicon and the electron and hole mobilities are approximate to each other. This semiconductor crystalline body is formed of lead chalcogenide. In Fig. 1, for example, PbTe is utilized as the lead chalcogenide constituting the films $A_1$ and $A_2$. P-conductivity type impurities are introduced into the PbTe monocrystalline film $A_1$ except a middle film region 12, corresponding to a channel region, by a known selective diffusion or ion-implantation technique, whereby two outer film regions 16 and 18 of the film $A_1$ has a p+-conductivity type. The two outer film regions 16 and 18 correspond to source and drain, respectively. As a result, a p-channel FET $Q_1$ is formed on the insulative substrate 10 to have the PbTe monocrystalline channel region 12 of n-conductivity type and the PbTe monocrystalline source and drain films 16 and 18 of p+-conductivity type. In the same manner as described above, n-conductivity type impurities are introduced into the other PbTe monocrystalline film $A_2$ except a channel region 14 so as to cause two outer film regions serving as source and drain regions 20 and 22 to have an n+-conductivity. Gate insulation films 24 and 26 are each formed on the films $A_1$ and $A_2$ each having a pnp junction structure and npn junction structure. These gate insulation films 24 and 26, preferably, are each formed of a thin film having a high dielectric constant such as that made of $Si_3N_4$, $Ta_2O_5$ and the like. Gate electrodes 32 and 34 are further deposited on these films 24 and 26, respectively. Thus, the p-channel metal-insulator semiconductor (MIS) FET $Q_1$ and the n-channel MISFET $Q_2$ are finally formed on the insulative substrate 10. Thereafter, wiring patterns 36-1, 36-2 and 36-3 consisting of metallic material such as platinum are formed on the above structure by a known technique. The patterns 36-1 and 36-2 are in contact with the PbTe films 16 and 22, thereby providing a source electrode (36-1) for the MISFET $Q_1$ and a drain electrode (36-2) for the MISFET $Q_2$, respectively. The PbTe films 18 and 20 are electrically connected to each other by means of the platinum layer 36-3. Further, the source electrode 36-1 of the MISFET $Q_1$ is connected to a power source terminal 40 to which a grounding potential or a potential $V_{ss}$ is applied, while the drain electrode 36-2 of the MISFET $Q_2$ is connected to another power source terminal 42 to which a voltage $V_{DD}$ is applied. The gate electrodes 32 and 34 of the MISFETs $Q_1$ and $Q_2$ are commonly connected, and at the same time, connected to a signal input terminal 44. The platinum layer 36-3 electrically connecting the drain 18 and source 20 included respectively in the MISFETs $Q_1$ and $Q_2$ is connected to a signal output terminal 46. With such a construction, the complementary inverter integrated circuit is actualized. Fig. 2 shows an equivalent circuit of the integrated circuit of Fig. 1.

The complementary inverter circuit including MISFETs $Q_1$ and $Q_2$ and having the foregoing construction exhibits an excellent high-speed characteristic as compared with a conventional integrated CMOS inverter circuit. The reasons for this are as follows: the monocrystalline thin films consisting of lead chalcogenide such as PbTe and formed by selective molecular beam epitaxy, which have an electron carrier mobility of approximately 1700 $cm^2/V \cdot sec$ and a hole carrier mobility of approximately 900 $cm^2/V \cdot sec$ at room temperature have, in the zone of liquid helium temperature, an electron carrier mobility as high as $5 \times 10^5$ $cm^2/V \cdot sec$ and a hole carrier mobility as high as approximately $3 \times 10^5$ $cm^2/V \cdot sec$. Thus, it is possible to easily manufacture (without using any special techniques a semiconductor integrated circuit of a complementary type exhibiting an ultra-high speed characteristic by using a relatively simple existing thin-film forming technique.

The lead chalcogenide based semiconductor materials generally have a high specific dielectric constant of several hundred. PbTe, one of the lead chalcogenide compounds, also has a specific dielectric constant as high as approximately 400. An increase in capacitance of the electrode section, which is attributable to such a high dielectric constant may therefore occur. According to the arrangement shown in Fig. 1, however, the monocrystalline thin film made of PbTe and constituting an active layer was formed on the insulative substrate 10 and therefore the increase in capacitance of the electrode section can be largely suppressed.

Further, the above-mentioned layer structure makes it easy to manufacture a ballistic device because the mean free path of the electron and hole carriers of lead chalcogenide in the temperature zone of liquid helium is as large as scores of micrometers. The fact that the mean free path of the carriers is long makes it possible to enlarge the scale of an active region of the ballistic device. The existing integrated element fabrication technique is therefore sufficient for manufacturing the ballistic device.

Further, when the monocrystalline thin film such as that made of $BaF_2$, $SrF_2$ and the like is formed as the gate insulative layer on the lead chalcogenide made film, it is possible to further improve the operational characteristics of MISFET because the interface property of MISFET is improved.

In Fig. 3 there is shown a complementary integrated inverter circuit according to one embodiment of the present invention. In Fig. 3, the MISFETs $Q_1$ and $Q_2$ are provided on a substrative body 50 comprised of an electrical conductive substrate 52 and an electrical insulative thin film 54 formed on the surface 52a of that substrate 52. The substrate 52 is composed of a monocrystalline bulk of PbTe or one of the lead chalcogenide compounds which is the same material as that used for the FETs $Q_1$ and $Q_2$. Further, the insulative thin film 54 consists of a monocrystalline material which is lattice-matched with the lead chalcogenide based semiconductive material, for example, $BaF_2$. In the arrangement shown in Fig. 1, the MISFETs $Q_1$ and $Q_2$ are formed directly on the cleavage plane 10a of the $BaF_2$ substrate 10 and therefore the PbTe thin film structures $A_1$ and $A_2$ constituting the FETs $Q_1$ and $Q_2$ are very likely to have imperfections and lattice defects due to stress on the cleavage plane 10a. As a result, the operation speed of the MISFETs $Q_1$ and $Q_2$ decreases. In contrast, according to the embodiment of Fig. 3, the irregularities in crystalline structure of the surface 52a of the PbTe substrate 52 are removed in the growth process of the $BaF_2$ insulative thin film 54 on the PbTe substrate 52. This reliably prevents lattice defects from being produced in the PbTe thin film structures $A_1$ and $A_2$.

Although the present invention has been shown and described with respect to a particular embodiment, various changes and modifications which are obvious to a person skilled in the art to which the invention pertains are deemed to lie within the scope of the invention.

The use of PbS or PbSe as the lead chalcogenide provides the same effect as that attainable by the preceding embodiment since the electron and hole mobilities are high in the temperature zone of liquid helium.

The above described lead chalcogenide based semiconductive material may be a mixed crystal of a plurality of materials selected from the group consisting of lead sulfide (PbS), lead selenide (PbSe) and lead telluride (PbTe).

Furthermore, the present invention can also be applied to what is called "A three-dimensional semiconductor integrated circuit device" constructed by using the monocrystalline thin film such as that made of the $BaF_2$, $SrF_2$ or the like as interlayer insulative films and stacking the lead chalcogenide monocrystalline thin films.

In the above-mentioned semiconductor device illustrated in Figure 3, it is apparent from Table 1 and Table 2 below that excellent carrier mobility can be obtained compared with the prior art even in a low temperature zone such as in the temperature zone of liquid helium and in that of liquid nitrogen as well. Table 1 given below shows the electron and hole mobilities of each of PbS, PbSe and PbTe in a temperature zone of liquid helium.

Table 1

| Material | Electron mobility $(cm^2/V \cdot sec)$ | Hole mobility $(cm^2/V \cdot sec)$ |
|---|---|---|
| PbS | $6 \times 10^4$ | $6 \times 10^4$ |
| PbSe | $1 \times 10^5$ | $1 \times 10^5$ |
| PbTe | $5 \times 10^5$ | $3 \times 10^5$ |

Table 2 presented below shows the electron and hole mobilities of each of PbS, PbSe and PbTe in a temperature zone of liquid nitrogen.

Table 2

| Material | Electron mobility $(cm^2/V \cdot sec)$ | Hole mobility $(cm^2/V \cdot sec)$ |
|---|---|---|
| PbS | $1.5 \times 10^4$ | $1.5 \times 10^4$ |
| PbSe | $2 \times 10^4$ | $2 \times 10^4$ |
| PbTe | $3 \times 10^4$ | $2 \times 10^4$ |

**Claims**

1. A semiconductor device having a substrative body (50) and first and second active elements formed on said substrative body (50) and performing a mutual and complementary switching operation,
characterised in that
said substrative body (50) comprises a substrate (52) having a surface and being composed of a monocrystalline bulk of lead chalcogenide based semiconductive material, and an insulative film (54) formed on the substrate surface and made of a monocrystalline dielectric material which is lattice-matched with the lead chalcogenide material constituting said substrate (52), and that
said first and second active elements comprise first and second metal-insulator-semiconductor field effect transistors or MISFETs (Q1, Q2) which are formed on said insulative film (54) to have gate insulation films (24, 26) made of monocrystalline dielectric material and which MISFETs are made of a lead chalcogenide based semiconductive material having electron and hole mobilities whose values are each greater by at least one order of magnitude than those of silicon material, said first and second MISFETs being prevented from being formed directly on said substrate (52), whereby irregularities in crystalline structure of the substrate surface are removed in the growth process of said insulative film (54) on said substrate (52), so that said first and second MISFETs (Q1, Q2) are prevented from having imperfections and lattice defects causing the operation speed thereof to be decreased.

2. The device according to claim 1, characterised in that said lead chalcogenide based semiconductive material is a material selected from the group consisting of lead sulfide, lead selenide, and lead telluride.

3. The device according to claim 2, characterised in that said first and second MISFETs (Q1, Q2) are made of the same material as used for said substrate (52).

4. The device according to claim 2 or 3, characterised in that said gate insulation films (24, 26) are made of the same monocrystalline dielectric material as used for said insulative film (54).

5. The device according to claim 1, characterised in that said lead chalcogenide based semiconductive material is a mixed crystal of a plurality of materials selected from the group consisting of lead sulfide (PbS), lead selenide (PbSe) and lead telluride (PbTe).

## Patentansprüche

1. Halbleiteranordnung (oder -schaltung) mit einem tragenden oder Substratkörper (50) sowie auf diesem ausgebildeten ersten und zweiten aktiven Elementen zur Durchführung einer gegenseitigen und komplementären Schaltoperation,

dadurch gekennzeichnet, daß

der Substratkörper (50) ein eine Oberfläche aufweisendes Substrat (52) aus einer monokristallinen Masse aus einem Halbleitermaterial auf der Basis von Bleichalkogenid und einen auf der Substratoberfläche ausgebildeten isolierenden Film (54) aus einem monokristallinen dielektrischen Material aufweist, das dem das Substrat (52) bildenden Bleichalkogenid-Material gitterangepaßt ist, und daß

erstes und zweites aktives Element erste und zweite Metallisolatorhalbleiter-Feldeffekttransistoren oder MISFETs (Q1, Q2) umfassen, die auf dem isolierenden Film (54) mit Gate-Isolierfilmen (24, 26) aus einem monokristallinen dielektrischen Material ausgebildet sind und die aus einem auf Bleichalkogenid basierenden Halbleitermaterial mit Elektronen- und Löcherbeweglichkeiten geformt sind, deren Werte jeweils um mindestens eine Größenordnung größer sind als diejenigen von Silizium-material, wobei eine unmittelbare Ausbildung von ersten und zweiten MISFETs auf dem Substrat (52) verhindert ist, so daß Unregelmäßigkeiten im Kristallgefüge der Substratoberfläche im Prozeß des Aufwachsens des isolierenden Films (54) auf dem Substrat (52) beseitigt sind und so daß Störstellen und Gitterdefekte bei ersten und zweiten MISFETs (Q1, Q2), durche welche deren Arbeitsgeschwindigkeiten herabgesetzt werden würden, vermieden sind.

2. Anordnung nach Anspruch 1, dadurch gekennzeichnet, daß das auf Bleichalkogenid basierende Halbleitermaterial ein Werkstoff aus der Gruppe Bleisulfid, Bleiselenid und Bleitellurid ist.

3. Anordnung nach Anspruch 2, dadurch gekennzeichnet, daß die ersten und zweiten MISFETs (Q1, Q2) aus demselben Material, wie es für das Substrat (52) verwendet wird, hergestellt sind.

4. Anordnung nach Anspruch 2 oder 3, dadurch gekennzeichnet, daß die Gate-Isolierfilme (24, 26) aus demselben monokristallinen dielektrischen Material, wie es für den isolierenden Film (54) verwendet wird, ausgebildet sind.

5. Anordnung nach Anspruch 1, dadurch gekennzeichnet, daß das auf Bleichalkogenid basierende Halbleitermaterial ein Mischkristall aus einer Anzahl von Materialien aus der Gruppe aus Bleisulfid (Pbs), Bleiselenid (PbSe) und Bleitellurid (PbTe) ist.

## Revendications

1. Un dispositif à semiconducteurs comportant une structure de substrat (50) et des premier et second éléments actifs formés sur cette structure de substrat (50) et accomplissant une opération de commutation mutuelle et complémentaire, caractérisé en ce que

la structure de substrat (50) comprend un substrat (52) ayant une surface et qui est constitué par un block monocristallin d'un matériau semiconducteur à base de chalcogénure de plomb, et une couche isolante (54) qui est formée sur la surface du substrat et qui est constituée par un matériau diélectrique dont le réseau cristallin est adapté à celui du matériau à base de chalcogénure de plomb constituant le substrat (52), et en ce que

les premier et second éléments actifs comprennent des premier et second transistors à effet de champ de type métal-isolant-semiconducteur, ou MISFET ($Q_1$, $Q_2$), qui sont formés sur la couche isolante (54) de façon à comporter des couches d'isolation de grille (24, 26) constituées par le matériau diélectrique monocristallin, et ces MISFET sont constitués par un matériau semiconducteur à base de chalcogénure de plomb ayant des mobilités des électrons et des trous dont les valeurs sont respectivement supérieures d'au moins un ordre de grandeur à celles du silicium, ces premier et second MISFET n'étant pas formés directement sur le substrat (52), grâce à quoi des irrégularités dans la structure cristalline de la surface du substrat sont éliminées dans le processus de croissance de la couche isolante (54) sur le substrat (52), ce qui fait que les premier et second MISFET ($Q_1$, $Q_2$) ne comportent pas des imperfections et des défauts du réseau cristallin provoquant une diminution de leur vitesse de fonctionnement.

2. Le dispositif de la revendication 1, caractérisé en ce que le matériau semiconducteur à base de chalcogénure de plomb est un matériau sélectionné dans le groupe qui comprend le sulfure de plomb, le séléniure de plomb et le tellurure de plomb.

3. Le dispositif selon la revendication 2, caractérisé en ce que les premier et second MISFET ($Q1$, $Q2$) sont constitués par le même matériau que le substrat (52).

4. Le dispositif selon la revendication 2 ou 3, caractérisé en ce que les couches d'isolation de grille (24, 26) sont constituées par le même matériau diélectrique monocristallin que la couche isolante (54).

5. Le dispositif selon la revendication 1, caractérisé en ce que le matériau semiconducteur à base de chalcogénure de plomb est un cristal mélangé comprenant un ensemble de matériaux sélectionnés dans le groupe qui comprend le sulfure de plomb (PbS), le séléniure de plomb (PbSe) et le tellurure de plomb (PbTe).

# F I G. 1

# F I G. 2

# F I G. 3